# EUROPEAN PATENT APPLICATION

(11) **EP 4 844 414 A1**
(43) Date of publication of application: **25.11.2026**
(21) Application number: 26166072.4
(22) Date of filing: 19.03.2026
(51) Int. Cl.: G01R 15/20

(54) **CORELESS CURRENT SENSOR HAVING AIR GAP SENSING**

(30) Priority: 21.05.2025 US 202519214517
(71) Applicant: Allegro MicroSystems, LLC, Manchester, NH 03103 (US)
(72) Inventor: FOLETTO, Andrea, 13811 Andorno Micca (IT); ROCK, Simon E., 69123 Heidelberg (DE); KULLA, Florian, 74000 Annecy (FR)
(74) Representative: South, Nicholas Geoffrey

(57) **Abstract**

Method and apparatus for a magnetic field sensor having a coreless current sensor configured for positioning in relation to a primary conductor to measure a flow of current in the primary conductor using a first sensing system, wherein the position of the current sensor and the primary conductor defines an airgap therebetween, and an airgap sensing system including a transmit coil to emit a transmit signal on the primary conductor and a second sensing system to detect a signal from the primary conductor in response to the transmit signal for obtaining information on the airgap. In embodiments, the sensor comprises an IC package.

## Description

### BACKGROUND

As is known in the art, some known current sensors provide coreless current sensing of a magnetic field generated by current passing through a conductor, such as a busbar or PCB, to allow non-intrusive current measurement while eliminating power loss associated with typical shunt sensing configurations. The sensitivity of coreless current sensing changes as a function of the airgap between the sensing element and the primary conductor and, therefore, normally requires system calibration. Airgap variation, due, for example, to assembly or mechanical expansion/contraction during the lifetime of the system, can generate an error for which it is difficult to recognize and provide acceptable compensation. In some cases, such as when the sensor is moved (or separated) from the primary conductor (or vice versa) due to some mechanical movement, failure or defect can occur. In such situations, the sensor is not able to detect the presence or the accurately determine distance of the primary conductor with the consequence that an incorrect current may be detected. In certain safety environments, incorrect current level information can lead to profound system damage because correct current detection cannot be performed.

### SUMMARY

Example embodiments of the disclosure provide methods and apparatus for current sensors having coreless current sensing and airgap sensing. In embodiments, a sensor includes a coil activated position sensor (CAPS) measurement system to measure the airgap between a coreless current sensor and a primary conductor without the need of additional external components and to provide galvanic isolation. A coreless current sensor measures current flow through the primary conductor. In embodiments, airgap measurement information for the coreless current sensor can be used to detect catastrophic failure and transition the system to a safe state if needed, as well as perform sensitivity compensation and calibration for enhanced accuracy.

In example embodiments, a CAPS system emits a high frequency electromagnetic field using an integrated coil in the sensor, which may be referred to as a transmit coil, on the primary conductor of the coreless sensor and measures, such as by using one or more MR elements, the specular (mirrored) magnetic field created in the primary conductor. The measured magnetic field is inversely proportional to the airgap (distance). This information can be used to detect the presence of the primary conductor and its distance/ airgap. In embodiments, this information is processed, such as in the coreless current sensor system, as diagnostic and/or sensitivity compensation/calibration for providing a robust, accurate and reliable current sensor.

In one aspect, a magnetic field sensor comprises: a coreless current sensor configured for positioning in relation to a primary conductor to measure a flow of current in the primary conductor using a first sensing system, wherein the position of the current sensor and the primary conductor defines an airgap therebetween; and an airgap sensing system including a transmit coil to emit a transmit signal on the primary conductor and a second sensing system to detect a signal from the primary conductor in response to the transmit signal for obtaining information on the airgap.

A sensor can further include or more of the following features: the sensor comprises an IC package, a processor to determine an airgap between the current sensor and the primary conductor, a diagnostic module to detect an invalid signal for the airgap, the diagnostic module is configured to generate an alert signal after detecting the invalid signal, the alert signal indicates an unsafe condition, the diagnostic module is configured to compare the signal from the primary conductor to a low threshold for generating the alert signal, the diagnostic module is configured to compare the signal from the primary conductor to a high threshold for generating the alert signal, a frequency range of the current in the primary conductor is separated from a frequency range of the transmit signal, the frequency range of the current in the primary conductor is in the kHZ range, the frequency range of the transmit signal is in the MHz range, the first sensing system includes a Hall element and/or an MR element, the second sensing system includes an MR element, sensing elements of the first sensing system are contained within a region defined by an inside of the transmit coil, the sensor is configured to ignore current measurements when detecting an invalid signal for the airgap, the sensor is configured to adjust a sensitivity of the current sensor based on a value of the airgap, and/or the coreless current sensor is configured to detect current flow above a given threshold.

In another aspect, a magnetic field sensor comprises: a coreless current sensor configured for positioning in relation to a primary conductor to measure a flow of current in the primary conductor using a first sensing system, wherein the position of the current sensor and the primary conductor defines an airgap therebetween; and an airgap sensing system including a transmit coil to emit a transmit signal on a primary conductor structure and a second sensing system to detect a signal from the primary conductor structure in response to the transmit signal for obtaining information on the airgap. The primary conductor structure can comprise the primary conductor and a metal structure positioned in relation to the primary conductor. Information on the airgap can correspond to the metal structure.

In another aspect, a method comprises: positioning a coreless current sensor, which form part of a magnetic field sensor, in relation to a primary conductor to measure a flow of current in the primary conductor using a first sensing system, wherein the position of the current sensor and the primary conductor defines an airgap therebetween; and configuring an airgap sensing system that comprises a transmit coil to emit a transmit signal on the primary conductor and a second sensing system to detect a signal from the primary conductor in response to the transmit signal for obtaining information on the airgap.

A method can further include determining an airgap between the current sensor and the primary conductor, generating an invalid signal for the airgap, comparing the signal from the primary conductor to a threshold for generating the alert signal, sensing elements of the first sensing system are contained within a region defined by an inside of the transmit coil, configuring the sensor to ignore current measurements when detecting an invalid signal for the airgap, and/or configuring the sensor to adjust a sensitivity of the current sensor based on a value of the airgap.

In another aspect, a method comprises: positioning a coreless current sensor in relation to a primary conductor to measure a flow of current in the primary conductor using a first sensing system, wherein the position of the current sensor and the primary conductor defines an airgap therebetween; and configuring an airgap sensing system that includes a transmit coil to emit a transmit signal on a primary conductor structure and a second sensing system to detect a signal from the primary conductor structure in response to the transmit signal for obtaining information on the airgap. The primary conductor structure may comprise the primary conductor and a metal structure positioned in relation to the primary conductor. The information on the airgap may correspond to the metal structure.

### BRIEF DESCRIPTION OF THE DRAWINGS

The foregoing features of this disclosure, as well as the disclosure itself, may be more fully understood from the following description of the drawings in which:
FIG. 1 shows a schematic representation of an example sensor system including a coreless current sensor and an airgap sensor;
FIG. 2 is a waveform diagram showing example frequency ranges for primary conductor current and coil transmission;
FIG. 3 is a waveform diagram showing CAPS signal response over airgap distance with thresholds for a valid signal range;
FIG. 4 shows a block diagram of an example sensor system including a coreless current sensor and an airgap sensor with a diagnostic module;
FIG. 5 is a schematic representation of an example sensor system including a coreless current sensor and an airgap sensor with an illustrative airgap sensor implementation; and
FIG. 6 is a schematic representation of an example compute that can perform at least a portion of the processing described herein.

### DETAILED DESCRIPTION

Some introductory information is provided prior to describing example embodiments of the disclosure. A sensed magnetic field, referred to herein alternatively as the applied magnetic field, can be from an external magnetic field source or a reflected field and can be amplified and fed back to the magnetic field sensing elements, e.g., MR elements, by a feedback coil such that the magnetic field sensing elements operate in a linear range. The feedback configuration can be a negative feedback configuration, in exemplary embodiments.

As used herein, the term "magnetic field sensor" is used to describe a circuit that uses one or more magnetic field sensing elements, generally in combination with other circuits. Magnetic field sensors are used in a variety of applications, including, but not limited to, angle sensors that sense an angle of a direction of a magnetic field, current sensors that sense a magnetic field generated by a current carried by a current-carrying conductor, magnetic switches that sense the proximity of a ferromagnetic object, rotation detectors that sense passing ferromagnetic articles, for example, magnetic domains of a ring magnet or a ferromagnetic target (e.g., gear teeth) where the magnetic field sensor is used in combination with a back-biased or other magnet, and magnetic field sensors that sense a magnetic field density of a magnetic field.

As used herein, the term "target" is used to describe an object or portion of an object to be sensed or detected by a magnetic field sensor or a magnetic field sensing element such as a magnetoresistance element. The target, such as a primary conductor or busbar, may include a conductive material that allows for eddy currents to flow within the target.

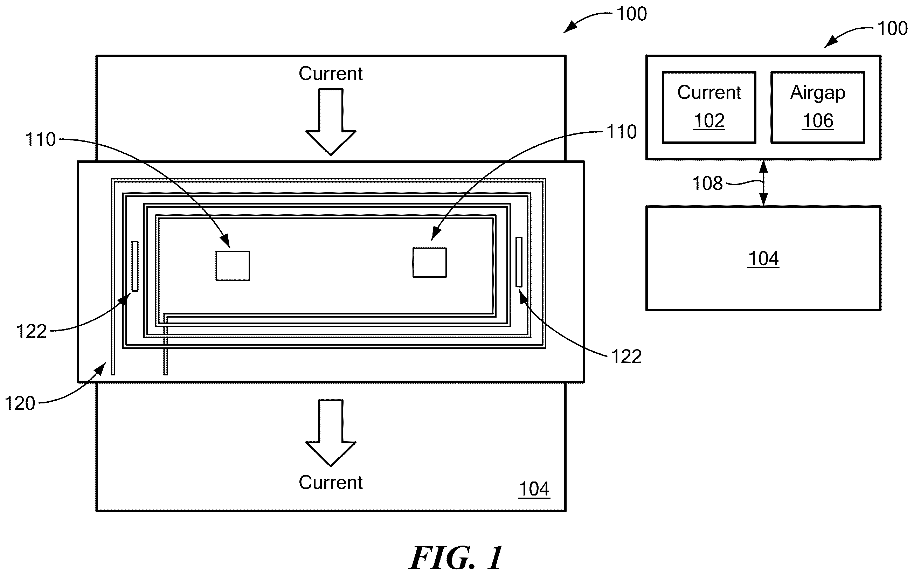

FIG. 1A is a top view and FIG. 1B is a block diagram (not to scale) of a side view of an example embodiment of a sensor system 100 including a coreless current sensor 102 for sensing current flow in a primary conductor 104 and an airgap sensor 106 for obtaining airgap information 108 for the primary conductor and the coreless current sensor. In embodiments, the airgap sensor 106 includes a CAPS measurement system to measure the airgap 108 between the coreless current sensor 102 and a primary conductor 104. In embodiments, an airgap measurement can be used to detect catastrophic failure for transitioning the system to a safe state if needed and/or performing compensation and calibration of the current sensitivity for enhanced accuracy, as described more fully below.

As used herein, a coreless current sensor refers to a type of current sensor that measures the magnetic field generated by current flowing through a conductor, such as a busbar or PCB trace, without requiring an external magnetic concentrator core or shield, and employ differential sensing techniques, such as differential Hall-effect or TMR technology.

In embodiments, a coreless current sensor IC integrates magnetic sensor and CAPS (airgap measurements) in a single device that may be implemented in multiple die or multiple devices to meet the needs of a particular application. Example applications include inverter current measurement, for example, of any high current application that requires diagnostic and safety functionality, such as battery disconnect (BDU), BMS, and the like.

The current sensor 102 can include one or more magnetic field sensing elements 110, such as GMR and/or TMR elements, positioned for differential sensing to cancel out undesirable stray magnetic fields. Current sensitivity in the current sensor 102 depends on the airgap 108 so calibration may be performed, for example, at the end of line during assembly. Over the operational life of the current sensor, variations in the airgap 108 can occur. Known devices may not be able to compensate for these variations without offline calibration.

In addition, known current sensors may not be able to detect that the primary conductor is lost. Conventional current sensors will detect this condition as zero current and thus, not protect the system against overcurrent conditions, which may be unsafe.

Example sensors are shown in U.S. Patent Nos. 10,935,612, and 11,555,832, and 10, 996,289, and 10,917,092, and 11,624,791 and U.S. Patent Publication Nos. 2024/003995, and 2023/298779, and 2023/417802 and 2023/258693, all of which are incorporated herein by reference.

Referring again to FIG. 1, the CAPS system 106 emits a high frequency electromagnetic field using a transmit coil 120 on the sensor. A primary conductor 104 is monitored by the coreless sensor 102 for measuring the magnetic field created in the primary conductor in response to the emitted high frequency electromagnetic field. The measured magnetic field is inversely proportional to the airgap 108. The measured field information can be used to detect the presence of the primary conductor 104 and its distance/ airgap. As described more fully below the measured field information can be processed to obtain diagnostic data and/or to provide sensitivity compensation/calibration.

The transmit coil 120 generates an electromagnetic field at high frequency, e.g., in the order of MHz, resulting in Eddy currents in the primary conductor 104. Airgap sensing elements 122, such as GMR and/or TMR elements, are used to read the magnetic field generated by the Eddy currents. The amplitude of the detected field is inversely proportional to the airgap 108.

In embodiments, the current flowing in the primary conductor (bus bar) 104 has a limited bandwidth, e.g., in the order of tens or hundreds of kHz. The magnetic field generated in the primary conductor 104 by the coil 120 is the MHz range to provide separation between the signals.

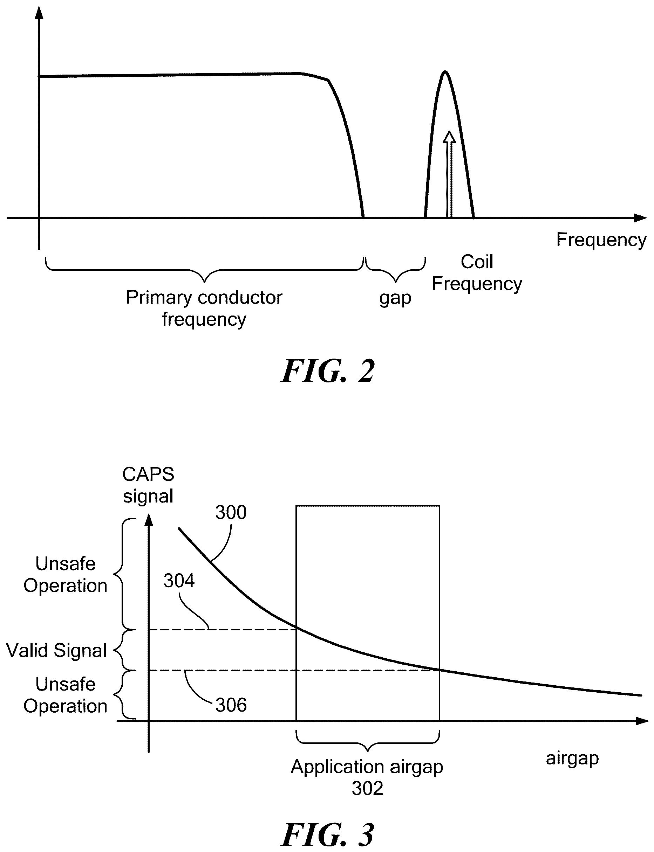

FIG. 2 shows signal amplitude over frequency for the current in the primary conductor and the coil transmission frequency. As can be seen, there is a frequency gap between the high end of the current frequency range and the low end of the coil frequency range to avoid interference between the signals.

In embodiments, the response of the CAPS is processed to obtain signal amplitude which corresponds to the airgap. Airgap information can be extracted by monitoring the Eddy current amplitude. The amplitude can be compared to one or more thresholds to identify error and/or unsafe conditions. When the airgap information is considered valid based on expected airgap positioning, the airgap information can be used to adjust the sensitivity of the coreless sensor. For example, the sensitivity can be increased if the airgap increases or reduced if the airgap decreases. By obtaining airgap information, the coreless current sensor can operate with a known airgap and thus enhance current measurement accuracy.

FIG. 3 shows an example waveform for the magnetic field amplitude 300 detected in the primary conductor in response to the emitted high frequency electromagnetic field over airgap distance. As can be seen, a valid signal corresponds to an airgap range 302. In the illustrated embodiment, a signal above a high threshold 304 or below a low threshold 306 indicates a potentially unsafe condition.

In embodiments, airgap measurements can be performed once, such as at start up, or continually depending on needs of a particular application. For example, airgap can be checked after power on and at selected times for sensitivity adjustment and/or diagnostics. It is understood that a wide range of airgap measurement schemes can be used to meet the needs of a particular application.

It is understood that airgap can refer to various distances from the target which is shown herein as a busbar. In embodiments, the target can have any practical geometry such as round, rectangular, and the like. Airgap can refer to a surface of the target to any surface of a sensor IC package, the distance to the sensing elements, or any other location that can be used to process the eddy current generated signal from the target.

As used herein, the term "airgap" refers to the physical distance or space between the magnetic sensing element (like a Hall-effect or TMR sensor) and the current-carrying conductor (such as a busbar or PCB trace).

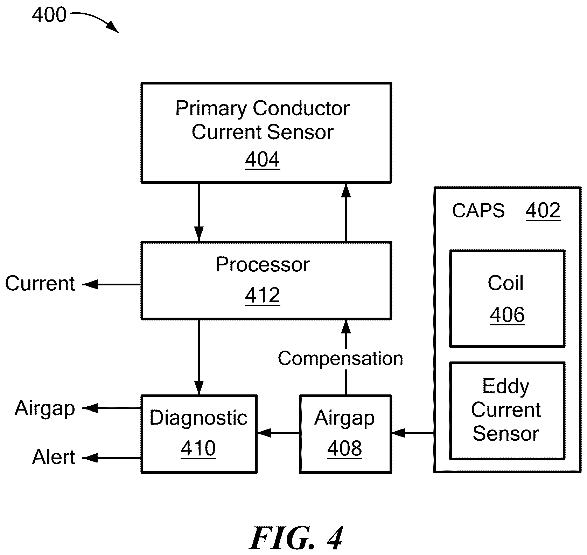

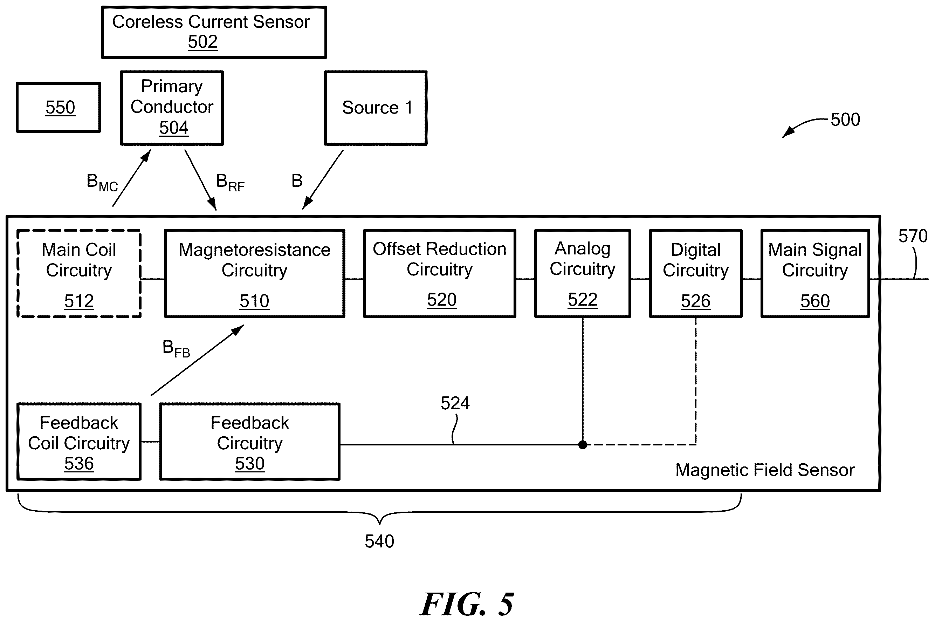

FIG. 4 shows an example sensor system 400 having a CAPS system 402 and a primary conductor current sensor 404. The CAPS system 402 includes a transmit coil 406 to generate a field and an eddy current sensor to measure the response. The CAPS system 402 provides the amplitude of the induced field (eddy current FIG. 5) to an airgap module 408 which extracts the airgap from the peak-to-peak and generates a compensation value if needed. A diagnostic module 410 coupled to the airgap module 408 checks the airgap and can provide the airgap information and/or peak-to-peak information and can also generate an alert or warning if the airgap is outside a predefined range. The alert signal may indicate unsafe conditions and transition a remote system to a safe mode.

In an example embodiment, the primary conductor current sensor 404 measures the current and receives compensation information from the airgap module 408 via a processor 412 configured to control the sensor and apply corrections.

FIG. 5 below shows a system 500 having a coreless current sensor 502 for measuring current in a primary conductor 504 and an example implementation of a CAPS system 506 for providing airgap information for the primary conductor.

In the illustrated embodiment, the CAPS system 506 includes magnetoresistance circuitry 510 that is part of a magnetic closed loop (a.k.a., feedback loop) 540 including feedback circuitry 530 and feedback coil circuitry 536 that generates a feedback magnetic field (B_{FB}). The magnetoresistance circuitry 510 is configured to sense or detect one or more magnetic fields, including a residual magnetic field (a.k.a., a resultant or error magnetic field) resulting from a combination of an external applied (B) or reflected (B_{RF}) magnetic field, which may be modulated at a first frequency (f₁), and the feedback magnetic field (B_{FB}).

In embodiments, the CAPS system may also measure also external magnetic field as the one generated by the current flowing (first frequency) in the primary conductor. The first frequency may be combined (sensor fusion) with the current sensor.

Offset reduction circuitry 520 is responsive to the magnetoresistance circuitry 510 and is configured to reduce undesired baseband components such as components attributable to the magnetoresistance circuitry 510. Example offset reduction circuitry 520 can take the form of AC coupling circuitry. The offset reduction circuitry 510 prevents undesired DC signal components from creating high frequency ripple, which would undesirably generate excessive power consumption due to current through the feedback coil and would increase the dynamic residual offset and thus, reduce the dynamic range of the system. Thus, stated differently, the offset reduction circuitry 520 prevents such ripple generation, thus optimizing power consumption, minimizing residual offset and maximizing output dynamic range (i.e., ensuring that the dynamic range of the system is available for processing the useful signal).

Analog circuitry 522, e.g., one or more amplifiers, and digital circuitry 526, e.g., one or more filters, can be used to process and/or condition the output signals of the offset reduction circuitry 520 to generate a feedback signal 524. The closed loop 540 is configured to use the feedback signal 524 to generate the feedback magnetic field (B_{FB}) and supply the feedback magnetic field (B_{FB}) to the magnetoresistance circuitry 510. The feedback loop 540 can be an analog closed loop as illustrated by the solid line feedback signal 524 from analog circuitry 522 or a digital closed loop as illustrated by the dotted line feedback signal 524 from the digital circuitry 526.

Main signal circuity 560 can process a main signal from the magnetoresistance circuitry 510, e.g., for measuring a position of the primary conductor, in order to generate a sensor output signal 570 that can be indicative of the position and/or motion.

The applied magnetic field can be a magnetic field (B) generated by a magnetic field source 1 and/or a reflected magnetic field (B_{RF}) reflected from the primary conductor 504. For embodiments sensing a reflected magnetic field (B_{RF}) reflected from the primary conductor, the sensed magnetic field can result from a main coil magnetic field (B_{MC}) that is generated by a main coil as part of main coil circuitry 512 that is reflected from the primary conductor as the reflected magnetic field (B_{RF}), with the reflected magnetic field allowing measurement of a parameter associated with the primary conductor.

In some embodiments, the induced field for measuring the airgap can be in the primary conductor or into a structure 550 mechanically linked and/or connected to it. For example, the induced field can comprise a metal structure 550 positioned in relation to the primary conductor.

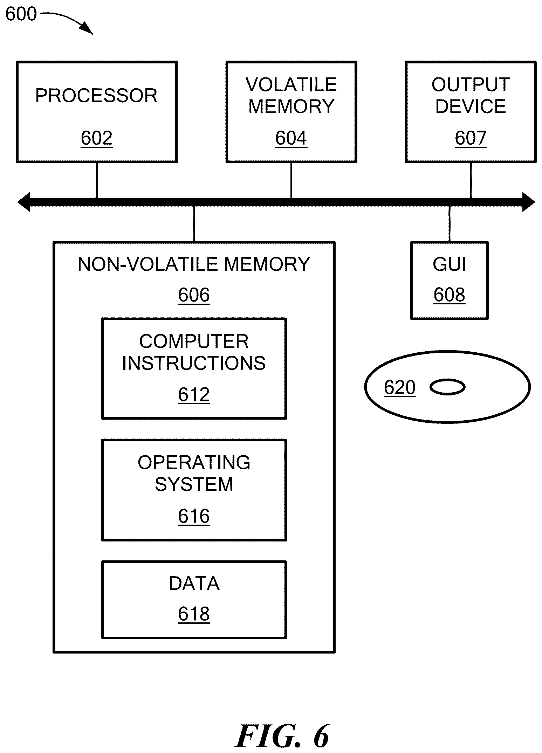

FIG. 6 shows an exemplary computer 600 that can perform at least part of the processing described herein. For example, the computer 600 can perform processing to control and/or process CAPS and/or coreless current sensor signals. The computer 600 includes a processor 602, a volatile memory 604, a non-volatile memory 606 (e.g., hard disk), an output device 607 and a graphical user interface (GUI) 608 (e.g., a mouse, a keyboard, a display, for example). The non-volatile memory 606 stores computer instructions 612, an operating system 616 and data 618. In one example, the computer instructions 612 are executed by the processor 602 out of volatile memory 604. In one embodiment, an article 620 comprises non-transitory computer-readable instructions.

Processing may be implemented in hardware, software, or a combination of the two. Processing may be implemented in computer programs executed on programmable computers/machines that each includes a processor, a storage medium or other article of manufacture that is readable by the processor (including volatile and non-volatile memory and/or storage elements), at least one input device, and one or more output devices. Program code may be applied to data entered using an input device to perform processing and to generate output information.

The system can perform processing, at least in part, via a computer program product, (e.g., in a machine-readable storage device), for execution by, or to control the operation of, data processing apparatus (e.g., a programmable processor, a computer, or multiple computers). Each such program may be implemented in a high-level procedural or object-oriented programming language to communicate with a computer system. However, the programs may be implemented in assembly or machine language. The language may be a compiled or an interpreted language and it may be deployed in any form, including as a stand-alone program or as a module, component, subroutine, or other unit suitable for use in a computing environment. A computer program may be deployed to be executed on one computer or on multiple computers at one site or distributed across multiple sites and interconnected by a communication network. A computer program may be stored on a storage medium or device (e.g., RAM/ROM, CD-ROM, hard disk, or magnetic diskette) that is readable by a general or special purpose programmable computer for configuring and operating the computer when the storage medium or device is read by the computer.

Processing may also be implemented as a machine-readable storage medium, configured with a computer program, where upon execution, instructions in the computer program cause the computer to operate.

Processing may be performed by one or more programmable processors executing one or more computer programs to perform the functions of the system. All or part of the system may be implemented as special purpose logic circuitry (e.g., an FPGA (field programmable gate array), a general purpose graphical processing units (GPGPU), and/or an ASIC (application-specific integrated circuit)).

Various embodiments of the concepts, systems, devices, structures, and techniques sought to be protected are described above with reference to the related drawings. Alternative embodiments can be devised without departing from the scope of the concepts, systems, devices, structures, and techniques described. For example, while reference is made above to use of magnetoresistance elements, other types of magnetic field sensing elements may be used within the scope of the present disclosure. Furthermore, implementations of the described techniques may include hardware, a method or process, or computer software on a computer-accessible medium. A system of one or more computers can be configured to perform particular operations or actions by virtue of having software, firmware, hardware, or a combination of them installed on the system that in operation causes or cause the system to perform the actions. One or more computer programs can be configured to perform particular operations or actions by virtue of including instructions that, when executed by data processing apparatus, cause the apparatus to perform the actions.

It is noted that various connections and positional relationships (e.g., over, below, adjacent, etc.) may be used to describe elements in the description and drawing. These connections and/or positional relationships, unless specified otherwise, can be direct or indirect, and the described concepts, systems, devices, structures, and techniques are not intended to be limiting in this respect. Accordingly, a coupling of entities can refer to either a direct or an indirect coupling, and a positional relationship between entities can be a direct or indirect positional relationship.

Also, the following definitions and abbreviations are to be used for the interpretation of the claims and the specification. The terms "comprise," "comprises," "comprising, "include," "includes," "including," "has," "having," "contains" or "containing," or any other variation are intended to cover a non-exclusive inclusion. For example, an apparatus, a method, a composition, a mixture, or an article, that includes a list of elements is not necessarily limited to only those elements but can include other elements not expressly listed or inherent to such apparatus, method, composition, mixture, or article.

Additionally, the term "exemplary" means "serving as an example, instance, or illustration. Any embodiment or design described as "exemplary" is not necessarily to be construed as preferred or advantageous over other embodiments or designs. The terms "one or more" and "at least one" indicate any integer number greater than or equal to one, i.e., one, two, three, four, etc. The term "plurality" indicates any integer number greater than one. The term "connection" can include an indirect "connection" and a direct "connection".

References in the specification to "embodiments," "one embodiment, "an embodiment," "an example embodiment," "an example," "an instance," "an aspect," etc., indicate that the embodiment described can include a particular feature, structure, or characteristic, but every embodiment may or may not include the particular feature, structure, or characteristic. Moreover, such phrases are not necessarily referring to the same embodiment. Further, when a particular feature, structure, or characteristic is described in connection with an embodiment, it may affect such feature, structure, or characteristic in other embodiments whether explicitly described or not.

Use of ordinal terms such as "first," "second," "third," etc., in the claims to modify a claim element does not by itself connote any priority, precedence, or order of one claim element over another, or a temporal order in which acts of a method are performed, but are used merely as labels to distinguish one claim element having a certain name from another element having a same name (but for use of the ordinal term) to distinguish the claim elements.

The disclosed subject matter is not limited in its application to the details of construction and to the arrangements of the components set forth in the following description or illustrated in the drawings. The disclosed subject matter is capable of other embodiments and of being practiced and carried out in various ways.

Also, the phraseology and terminology used in this patent are for the purpose of description and should not be regarded as limiting. As such, the conception upon which this disclosure is based may readily be utilized as a basis for the designing of other structures, methods, and systems for carrying out the several purposes of the disclosed subject matter. Therefore, the claims should be regarded as including such equivalent constructions as far as they do not depart from the spirit and scope of the disclosed subject matter.

Although the disclosed subject matter has been described and illustrated in the foregoing exemplary embodiments, the present disclosure has been made only by way of example. Thus, numerous changes in the details of implementation of the disclosed subject matter may be made without departing from the spirit and scope of the disclosed subject matter.

Accordingly, the scope of this patent should not be limited to the described implementations but rather should be limited only by the spirit and scope of the following claims. All publications and references cited in this patent are expressly incorporated by reference in their entirety.

## Claims

1. A magnetic field sensor, comprising:
a coreless current sensor configured for positioning in relation to a primary conductor to measure a flow of current in the primary conductor using a first sensing system, wherein the position of the current sensor and the primary conductor defines an airgap therebetween; and
an airgap sensing system including a transmit coil to emit a transmit signal on the primary conductor and a second sensing system to detect a signal from the primary conductor in response to the transmit signal for obtaining information on the airgap.

2. The sensor according to claim 1, wherein the sensor comprises an IC package.

3. The sensor according to claim 1, further including a processor to determine an airgap between the current sensor and the primary conductor.

4. The sensor according to claim 3, further including a diagnostic module to detect an invalid signal for the airgap.

5. The sensor according to claim 3, wherein the diagnostic module is configured to generate an alert signal after detecting the invalid signal.

6. The sensor according to claim 5, wherein the alert signal indicates an unsafe condition.

7. The sensor according to claim 5, wherein the diagnostic module is configured to compare the signal from the primary conductor to a low threshold for generating the alert signal.

8. The sensor according to claim 7, wherein the diagnostic module is configured to compare the signal from the primary conductor to a high threshold for generating the alert signal.

9. The sensor according to claim 1, wherein a frequency range of the current in the primary conductor is separated from a frequency range of the transmit signal.

10. The sensor according to claim 9, wherein the frequency range of the current in the primary conductor is in the kHZ range.

11. The sensor according to claim 10, wherein the frequency range of the transmit signal is in the MHz range.

12. The sensor according to claim 1, wherein the first sensing system includes a Hall element and/or an MR element.

13. The sensor according to claim 12, wherein the second sensing system includes an MR element.

14. The sensor according to claim 1, wherein the coreless current sensor is configured to detect current flow above a given threshold.

15. A magnetic field sensor, comprising:
a coreless current sensor configured for positioning in relation to a primary conductor to measure a flow of current in the primary conductor using a first sensing system, wherein the position of the current sensor and the primary conductor defines an airgap therebetween; and
an airgap sensing system including a transmit coil to emit a transmit signal on a primary conductor structure and a second sensing system to detect a signal from the primary conductor structure in response to the transmit signal for obtaining information on the airgap.

16. A method, comprising:
positioning a coreless current sensor, which form part of a magnetic field sensor, in relation to a primary conductor to measure a flow of current in the primary conductor using a first sensing system, wherein the position of the current sensor and the primary conductor defines an airgap therebetween; and
configuring an airgap sensing system that comprises a transmit coil to emit a transmit signal on the primary conductor and a second sensing system to detect a signal from the primary conductor in response to the transmit signal for obtaining information on the airgap.

17. The method according to claim 16, further including determining an airgap between the current sensor and the primary conductor.

18. The method according to claim 17, further including generating an invalid signal for the airgap.

19. The method according to claim 17, further including comparing the signal from the primary conductor to a threshold for generating an alert signal.

20. The method according to claim 16, or the sensor according to claim 1, wherein sensing elements of the first sensing system are contained within a region defined by an inside of the transmit coil.

21. The method according to claim 16, or the sensor according to claim 1, wherein the sensor is configured to ignore current measurements when detecting an invalid signal for the airgap.

22. The method according to claim 16, or the sensor according to claim 1, wherein the sensor is configured to adjust a sensitivity of the current sensor based on a value of the airgap.

23. A method, comprising:
positioning a coreless current sensor in relation to a primary conductor to measure a flow of current in the primary conductor using a first sensing system, wherein the position of the current sensor and the primary conductor defines an airgap therebetween; and
configuring an airgap sensing system that includes a transmit coil to emit a transmit signal on a primary conductor structure and a second sensing system to detect a signal from the primary conductor structure in response to the transmit signal for obtaining information on the airgap.

24. The method according to claim 23, or the sensor according to claim 15, wherein the primary conductor structure comprises the primary conductor and a metal structure positioned in relation to the primary conductor.

25. The method according to claim 23, or the sensor according to claim 15, wherein the primary conductor structure comprises the primary conductor and a metal structure positioned in relation to the primary conductor, and the information on the airgap corresponds to the metal structure.
